# FASCICULE DE BREVET EUROPEEN

(11) **EP 1 525 340 B1**
(45) Date de publication et mention de la délivrance du brevet: **21.09.2011**
(21) Numéro de dépôt: 03750838.9
(22) Date de dépôt: 24.07.2003
(51) Int. Cl.: C30B 25/02

(54) **PROCEDE DE REALISATION PAR EPITAXIE EN PHASE VAPEUR D UN FIL M DE NITRURE DE GALLIUM A FAIBLE DENSITE DE DEFAUT**
VERFAHREN ZUR HERSTELLUNG EINES FILMS AUS GALLIUMNITRID MIT NIEDRIGER FEHLERDICHTE DURCH DAMPFPHASEEPITAXIE
METHOD FOR PRODUCING BY VAPOUR-PHASE EPITAXY A GALLIUM NITRIDE FILM WITH LOW DEFECT DENSITY

(30) Priorité: 24.07.2002 FR 0209375
(43) Date de publication de la demande: 27.04.2005
(73) Titulaire: Saint-Gobain Cristaux & Détecteurs, 92400 Courbevoie (FR)
(72) Inventeur: BEAUMONT, Bernard, F-06530 LE TIGNET (FR); GIBART, Pierre, F-06740 Châteauneuf de Grasse (FR); FAURIE, Jean-Pierre, F-06560 Valbonne (FR)
(74) Mandataire: Texier, Christian
(86) Numéro de dépôt international: PCT/FR2003/002340
(87) Numéro de publication internationale: WO 2004/012227

(56) Documents cités:
- EP-A- 0 942 459
- EP-A- 1 005 068
- EP-A- 1 088 914
- WO-A-99/20816
- VENNEGUES P ET AL: "REDUCTION MECHANISMS FOR DEFECT DENSITIES IN GAN USING ONE- OR TWO-STEP EPITAXIAL LATERAL OVERGROWTH METHODS" JOURNAL OF APPLIED PHYSICS, AMERICAN INSTITUTE OF PHYSICS. NEW YORK, US, vol. 87, no. 9, 1 mai 2000 (2000-05-01), pages 4175-4181, XP001059909 ISSN: 0021-8979 cité dans la demande
- HIRAMATSU K ET AL: "Fabrication and characterization of low defect density GaN using facet-controlled epitaxial lateral overgrowth (FACELO)" JOURNAL OF CRYSTAL GROWTH, NORTH-HOLLAND PUBLISHING CO. AMSTERDAM, NL, vol. 221, no. 1-4, décembre 2000 (2000-12), pages 316-326, XP004226877 ISSN: 0022-0248
- HEYING B ET AL: "DISLOCATION MEDIATED SURFACE MORPHOLOGY OF GAN" JOURNAL OF APPLIED PHYSICS, AMERICAN INSTITUTE OF PHYSICS. NEW YORK, US, vol. 85, no. 9, 1 mai 1999 (1999-05-01), pages 6470-6476, XP001090818 ISSN: 0021-8979 cité dans la demande
- ZHANG L ET AL: "EFFECT OF SB AS A SURFACTANT DURING THE LATERAL EPITAXIAL OVERGROWTH OF GAN BY METALORGANIC VAPOR PHASE EPITAXY" APPLIED PHYSICS LETTERS, AMERICAN INSTITUTE OF PHYSICS. NEW YORK, US, vol. 79, no. 19, 5 novembre 2001 (2001-11-05), pages 3059-3061, XP001108160 ISSN: 0003-6951 cité dans la demande

## Description

La présente invention concerne l'élaboration de films de nitrure de gallium (GaN) par épitaxie en phase vapeur avec de faibles densités de défauts.
Elle concerne aussi les composants optoélectroniques et électroniques élaborés à partir de ces films de nitrure de gallium.
Fin 1995, la société Nichia a fabriqué une diode laser réalisée à partir de nitrures III-V. Un tel résultat a montré qu'on pouvait obtenir une émission laser dans une structure hétéroépitaxiale où la densité de dislocations atteignait 10⁸ à 10¹⁰cm⁻². Fin 1997, Nichia a démontré que l'on pouvait obtenir une émission laser pendant 10000 heures à condition que la structure de la diode laser soit réalisée sur une couche de GaN de bonne qualité. Il s'agissait de couches de GaN élaborées selon la technologie de surcroissance épitaxiale latérale ELO (Epitaxial Lateral Overgrowth).
Bien que l'on ait longtemps affirmé que les dislocations dans GaN n'agissaient pas comme centres de recombinaison non radiative, il est aujourd'hui établi qu'en fait certaines dislocations à composante vis introduisent des centres non-radiatifs et que les performances des composants sont bien supérieures sur une structure de meilleure qualité cristallographique. Ainsi la durée de vie des diodes laser à base de nitrure III-V dépend de manière critique de la densité de dislocations dans les couches de GaN sur lesquelles sont fabriquées les structures.
Tous les efforts actuels convergent vers l'obtention de GaN hétéroépitaxié avec la meilleure qualité cristalline possible. C'est pourquoi la technique de surcroissance par épitaxie latérale (ELO) a été largement développée pour GaN avec de nombreuses variantes.
Comme il n'existe pas de substrats massifs de GaN disponibles d'une surface satisfaisante et en quantité suffisante, les composants à base de nitrure III-V sont élaborés par hétéroépitaxie sur des substrats tels que le saphir, SiC, Si ou autre. Le saphir couramment utilisé comme substrat ne possède pas de plan de clivage, ce qui implique que dans une structure de diode laser à base de GaN épitaxié sur saphir, il est difficile de fabriquer des facettes réfléchissantes.
Par ailleurs, l'utilisation d'un substrat comme le saphir présentant à la fois un désaccord de paramètre de réseau et de coefficient de dilatation thermique génère une densité de dislocations très élevée dans les couches hétéroépitaxiales de GaN/saphir.
Quelle que soit la technologie, la densité des défauts étendus : dislocations, fautes d'empilement, domaines d'inversion, nanotubes ne descend pas en dessous de 5.10⁸cm⁻². Les dislocations se propagent dans la direction de croissance et émergent en surface où elles peuvent être identifiées par microscopie à force atomique (AFM) ou en cathodoluminescence (CL). Ces dislocations sont néfastes à plusieurs points de vue. D'abord, en densité élevée (supérieure à 5x10⁸cm⁻²), les défauts dégradent la mobilité électronique ainsi que les propriétés électroniques (intensité de photoluminescence, durée de vie des porteurs). De plus, l'émergence des dislocations en surface se traduit par une dépression en surface (Heying et al., J. Appl. Phys., 85, 6470, 1999). Dans une structure de diode laser à base de multipuits quantiques (MQWs) GalnN, les dislocations perturbent l'ordonnancement des MQWs et provoquent une émission lumineuse non-homogène. Enfin, les métaux utilisés pour les contacts ohmiques peuvent aussi diffuser à travers ces dislocations et nanotubes.
Différentes technologies de surcroissance épitaxiale latérale ont été développées pour la mise en oeuvre de l'ELO : 1) par HVPE (Hydride Vapor Phase Epitaxy ou épitaxie en phase vapeur à partir de chlorures et d'hydrures), 2) par EPVOM (épitaxie en phase vapeur par pyrolyse d'organométalliques) 3) par pseudo-sublimation ou plus précisément CSVT pour Close Space Vapor Transport et 4) diverses variantes sans masque utilisant par exemple des substrats gravés. Toutes permettent d'obtenir des couches de GaN avec des densités de dislocations inférieures à 10⁷ cm⁻² comparées à 10⁸ à 10¹⁰ avec la technologie standard. Cependant, comme nous le verrons ci-après, et c'est inhérent à la technologie employée, il reste des zones où la densité de dislocations reste élevée, au-dessus d'ouvertures et de joints de coalescence dans une technologie à une étape d'épitaxie, aux joints de coalescence et au milieu des ouvertures dans une technologie à deux étapes où, lors d'une première étape on procède au dépôt par épitaxie de GaN dans les ouvertures après avoir masqué et gravé (notamment par photolithographie) une couche de diélectrique pour former ces dites ouvertures et où, lors d'une deuxième étape de surcroissance épitaxiale latérale (ELO) on procède à la croissance latérale des motifs de GaN tout d'abord déposés que l'on poursuit jusqu'à leur coalescence.
Une variante connue de la technologie de croissance s'appuie sur l'épitaxie en phase vapeur par pyrolyse d'organométalliques (EPVOM) selon un processus désormais bien établi (sur saphir) : traitement de la surface sur saphir, nucléation à basse température d'une couche de GaN ou AIN, recuit jusqu'à la température de croissance finale de cette couche de nucléation et croissance à haute température de GaN (1000-1100°C). Plusieurs technologies ont été développées pour optimiser au mieux cette hétéroépitaxie et limiter à environ 5x10⁸cm⁻² la densité de dislocation dans GaN (coalescence d'îlots de GaN, Haffouz et al, Appl. Phys. Lett., 73 ; 1278(1998), X.H. Wu et al, Jpn. J. Appl. Phys., 35, L1648(1996)).
Sur SiC, la couche de nucléation à basse température n'est plus nécessaire, on réalise d'abord une couche de AIN à haute température avant le dépôt de GaN. Toutefois la densité de dislocations reste sensiblement de l'ordre d'environ 5x10⁸cm⁻².
Ainsi, comme exposé ci-dessus, la surcroissance par épitaxie latérale (ELO) avec de nombreuses variantes, constitue l'une des méthodes les plus pertinentes pour réduire la densité de dislocations de plusieurs ordres de grandeur, c'est à dire inférieure à environ 10⁷cm⁻².
Afin de mieux comprendre le cadre de l'invention, on décrit ci-après la façon dont se propagent les lignes de défauts dans le GaN dans un premier temps, lorsque l'on utilise le procédé ELO à une étape d'épitaxie et dans un deuxième temps, lorsque l'on utilise le procédé à deux étapes.

### Procédé à une étape d'épitaxie

On épitaxie d'abord une première couche de GaN sur un substrat, puis on dépose un masque de diélectrique sur cette couche. Ensuite on pratique par photolithographie des ouvertures dans ce masque de diélectrique de dimensions et d'orientations cristallographiques bien définies. On effectue la reprise d'épitaxie sur les couches de GaN ainsi préparées d'abord dans les ouvertures ; cette reprise d'épitaxie conduit à une croissance latérale des cristaux de GaN qui a pour effet de diminuer de plusieurs ordres de grandeur la densité de dislocations. En effet, les dislocations traversantes ne se propagent pas au dessus du masque. Par contre, GaN qui s'épitaxie à partir des ouvertures, en cohérence avec GaN de départ, garde la même densité de dislocation que le composé de départ. Par ailleurs, les motifs latéraux, à faible densité de dislocations coalescent et, comme GaN initial présente une mosaïcité, leur faible désorientation respective conduit à une région à forte densité de dislocations dans le plan de coalescence ou joint de coalescence. En conséquence, dans l'ELO à une étape, toute la surface n'est pas utilisable pour la fabrication des composants optoélectroniques.

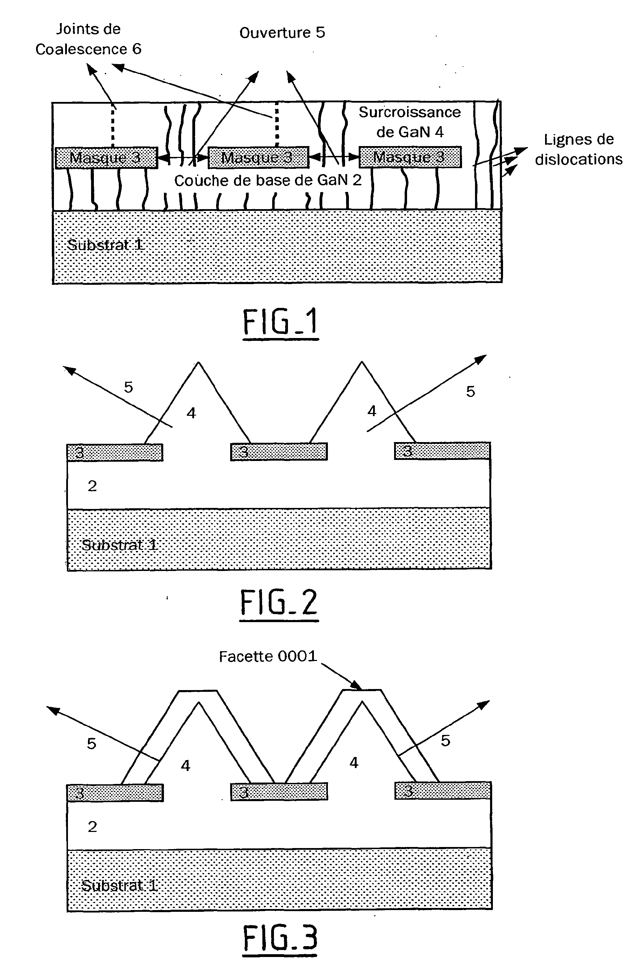

La figure 1 schématise ce procédé à une étape d'épitaxie. Sur un substrat 1, une couche de GaN est épitaxiée (couche de base de GaN 2). Ensuite un masque 3 (SiO₂, SiNₓ, Al₂O₃, W, etc) est déposé (par CVD, PACVD, pulvérisation cathodique, sublimation, CVD *in situ* ou toute autre méthode de dépôt). Sur ce masque, des ouvertures sont pratiquées par photolithographie, le long de directions cristallographiques bien définies et avec des dimensions appropriées, par exemple des ouvertures de 3 µm séparées de 7 µm le long de la direction [1-100]_{GaN}. Lors de la reprise de croissance de GaN, le dépôt s'effectue d'abord dans les ouvertures 5, puis latéralement au dessus du masque 4. Au dessus des ouvertures, GaN en relation épitaxique avec le substrat, garde la même densité de défauts que la couche de base 2. Les lignes noires de la figure 1 représentent les lignes de dislocation. Le GaN croit latéralement au dessus du masque (surcroissance de GaN 4). Dans cette zone, les dislocations traversantes ne se propagent pas, ceci est établit par l'état de l'art actuel. Par contre, lorsque les deux fronts de surcroissance latérale se rejoignent au milieu du masque il se forme un joint de coalescence 6. La technologie de fabrication de diode laser sur substrat ELO tels que décrits ci-dessus nécessite donc une technologie complexe car la structure des diodes doit être réalisée sur les zones de surcroissance 4, entre le joint de coalescence et la zone en relation épitaxique avec le substrat, ce qui exige une précision de l'alignement de l'ordre du µm.

### Procédé à deux étapes d'épitaxie

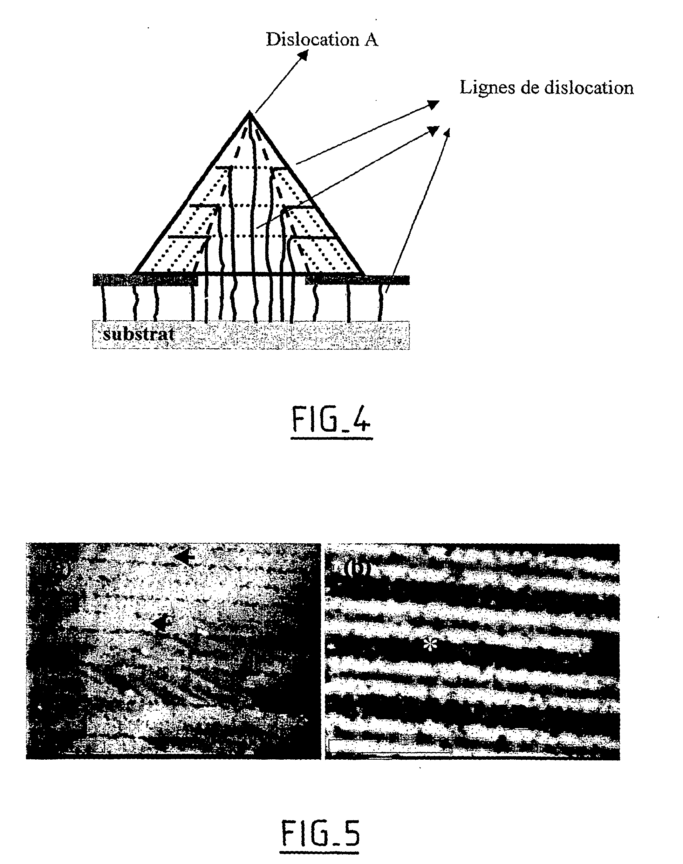

Cette variante constitue une amélioration du procédé à une étape d'épitaxie. Elle est schématisée par les figures 2, 3 et 4.
Les figures 2 et 3 s'analysent comme suit :
Après avoir épitaxié une couche de base de GaN, référencée 2, sur un substrat de saphir, référencé 1 on réalise *in situ* un dépôt de SiN (masques 3) puis, sur ce masque de diélectrique, on grave par photolithographie des ouvertures 5 selon des directions cristallographiques bien définies. Finalement, on reprend la croissance qui donne d'abord une surcroissance épitaxiale sélective 6.
Lors de la première reprise d'épitaxie, les conditions de croissance sont ajustées pour obtenir une vitesse de croissance le long de la direction <0001> supérieure à la vitesse de croissance latérale de telle sorte que l'on obtient une surcroissance sous forme de bandes à section triangulaire présentant des facettes {11-22}. L'intérêt de cette procédure est d'induire une courbure des dislocations émergentes à 90° comme illustré dans la Figure 4.
Cette courbure des dislocations s'explique par des considérations énergétiques. La force agissant sur une ligne de dislocation est la somme de 2 termes,
- l'une courbe cette ligne pour qu'elle reste normale à la surface,
- l'autre tend à aligner la ligne de dislocation avec le vecteur de Burgers (pour minimiser l'énergie de formation de la dislocation).

Lors de la seconde étape, les conditions expérimentales sont modifiées pour avoir une vitesse de croissance latérale supérieure à celle selon la direction <0001> pour obtenir une coalescence totale. La Figure 3 montre une étape intermédiaire où la facette (0001) 7 réapparaît.
Ce procédé à deux étapes est notamment décrit dans la demande de brevet WO99/20816. La modification des conditions expérimentales pour obtenir une vitesse de croissance latérale supérieure à celle selon la direction <0001> peut consister en l'ajout de magnésium, d'antimoine (Sb) ou de bismuth (Bi) pour provoquer une anisotropie de la croissance de GaN (L. Zhang, et al, Appl.Phys. Lett., 79, 3059 (2001).

Cette technologie permet d'obtenir GaN avec des densités de dislocations inférieures ou égales à 10⁷cm⁻² (sur toute la surface entre les zones de coalescence)( Vennéguès et al, J. Appl. Phys. 87, 4175 (2000)).
Entre les zones de coalescence il existe des régions pratiquement sans défauts observables comme le montrent les images de la surface en cathodoluminescence présentées sur la figure 5, où la partie (a) de la figure est une image d'une couche de GaN obtenue par un procédé à 2 étapes d'épitaxie et où la partie (b) est une image d'une couche de GaN obtenue par un procédé à une étape d'épitaxie.
Ces zones de faible densité de défauts sont suffisamment larges pour réaliser des composants optoélectroniques comme les diodes laser. L'examen attentif de ces images montre qu'il existe aussi sensiblement au milieu des bandes définies par les zones de coalescence une densité de points noirs (émergence de dislocations) sensiblement plus élevée que celle du reste de la bande à faible densité de défauts. Il s'agit de dislocations ayant leur origine dans la couche de GaN de base, situées au milieu des ouvertures, qui après la première étape de croissance émergent vers le sommet des surcroissances triangulaires, et qui ainsi échappent au processus de courbure des dislocations. En effet, lors de la croissance ELO, après épitaxie sélective, les conditions expérimentales sont telles que les facettes {11-22} commencent à se former, et les dislocations traversantes au bord du masque se courbent en premier. La figure 4 permet de bien comprendre ce phénomène. Les dislocations au milieu du masque peuvent échapper à se processus et émerger en surface (dislocation A). Par ailleurs, après courbure, les dislocations se propagent parallèlement au plan de base. Les deux fronts de surcroissance latérale se rencontrent et créent un joint de coalescence. Les dislocations qui suivent le front de croissance latéral peuvent soit se terminer dans la zone de coalescence (où il peut y avoir un vide), soit se courber vers le substrat, soit encore se courber à 90° et émerger en surface. Ce joint de coalescence où la densité de dislocations traversantes est élevée limite aussi la surface utilisable du substrat ELO.
On constate donc que ce procédé à deux étapes d'épitaxie ne permet pas d'éliminer toutes les dislocations et en particulier les dislocations provenant du milieu des masques et des joints de coalescence.
Pour compléter la description et pour bien comprendre le cadre de l'invention qui va suivre, on décrit ci-après la propagation des lignes de dislocations. On s'intéresse en particulier ci-après aux dislocations ayant leur origine en milieu des ouvertures du masque.

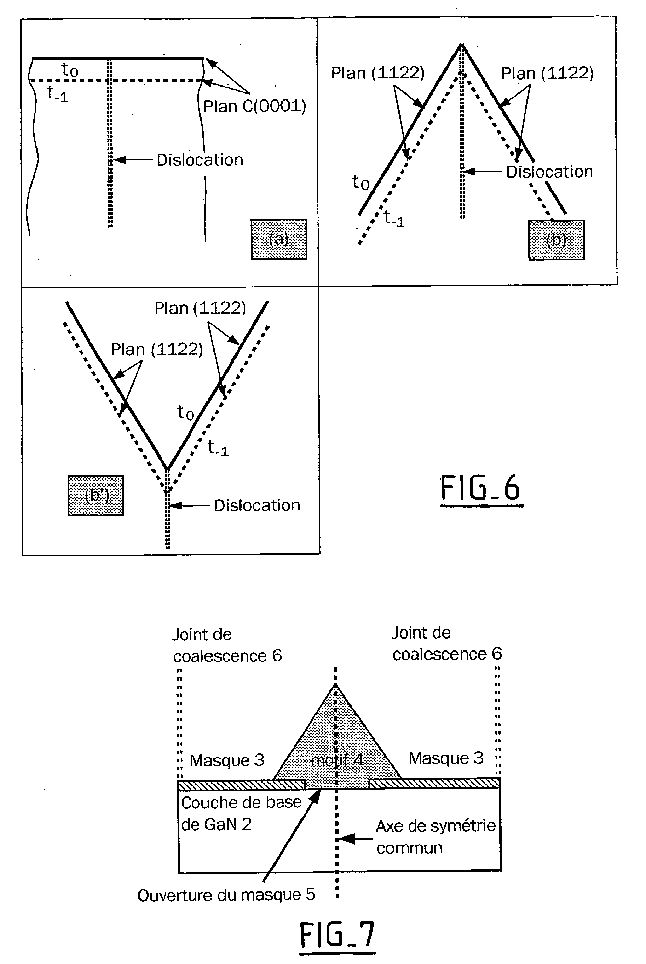

Les figures 6 et 7 illustrent le cas où les dislocations sont susceptibles d'émerger en surface. Dans la suite de la description, on se référera à cette figure lorsqu'on évoquera les différents types de symétrie que l'on peut rencontrer (a), (b) ou (b').
La figure 7 illustre le cas de figure où le motif 4 de section trapézoïdale ou triangulaire et le masque 3 ont un axe de symétrie commun. Les dislocations émergentes se trouvant au sommet de la section triangulaire 4 et les joints de coalescence 6 forment des plans verticaux. L'environnement d'une dislocation dont la ligne coïncide avec l'axe de symétrie commun est d'abord une configuration (a) puis (b) puis de nouveau (a) lors de la croissance : elle ne se courbe jamais. De même l'environnement d'une dislocation du joint de coalescence est lors de la croissance une configuration de type (b') puis (a) : il n'a pas de courbure de sa ligne.

D'autres variantes de la technologie ELO en phase vapeur n'utilisent pas de masque de diélectrique, mais des substrats texturés ou périodiquement gravés (Ashby et al. Appl. Phys. Lett. 77, 3233(2000). Dans ces technologies, des gravures sont effectuées directement sur le substrat, ce qui évite une étape de croissance et le dépôt d'un masque.

Cette technique ne permet pas non plus d'éliminer toutes les dislocations et en particulier les dislocations provenant du milieu des ouvertures et des joints de coalescence.

Il existe donc un fort besoin de trouver des solutions techniques à ce problème des dislocations émergeant à la surface des films de GaN qui réduisent les surfaces utilisables de films de GaN pour la fabrication des composants optoélectroniques, quel que soit le procédé de réalisation du film adopté, à une, deux, voire plusieurs étapes d'épitaxie ou encore à gravure d'ouvertures directement dans le substrat.
Le but de l'invention est de proposer un procédé de réalisation d'un film de GaN qui fournisse un film de GaN avec de faibles densités de défaut.
Il est précisé que dans le cadre de la présente invention, le GaN peut être dopé ou non. A titre de substances dopantes on peut notamment citer le magnésium, le zinc, le béryllium, le calcium, le carbone, le silicium, l'oxygène, l'étain, le germanium. On peut aussi introduire une impureté isolélectronique comme le In, Sc, Sb, Bi parmi les éléments de la colonne III ou V du tableau périodique de Mendéleev.
Ainsi l'invention a pour objet un procédé selon la revendication 1 de réalisation d'un film de nitrure de gallium (GaN) à partir d'un substrat, par dépôt de GaN par épitaxie en phase vapeur, caractérisé en ce que le dépôt de GaN comporte au moins une étape de surcroissance épitaxiale latérale en phase vapeur (ELO), en ce qu'au moins une de ces étapes d'ELO est précédée d'une gravure d'ouvertures
- soit dans un masque de diélectrique préalablement déposé,
- soit directement dans le substrat,
et en ce que l'on introduit une dissymétrie dans l'environnement des dislocations lors d'une des étapes d'ELO de façon à provoquer le plus grand nombre de courbures des dislocations, les dislocations courbées n'émergeant pas à la surface de la couche de GaN ainsi obtenue.

La dissymétrie de l'environnement des dislocations est notamment induite :
(1) en agissant sur les paramètres de la croissance soit en appliquant un champ électrique perpendiculaire à l'axe de croissance, soit encore en éclairant à l'aide d'une lampe produisant un rayonnement UV autour de 170 à 400 nm, pour faire croître préférentiellement une seule famille de facettes {11-22} ou encore;
(2) en réalisant des ouvertures de largeurs ou de géométrie inégales soit dans le masque de diélectrique soit directement dans le substrat pour faire prendre des formes géométriques aux motifs de GaN favorables à la courbure des dislocations ou autrement dit en exploitant les propriétés spécifiques des différentes formes géométriques que peuvent prendre les motifs de GaN lors de la reprise de croissance ;

Cette dissymétrie permet d'agir sur la majorité des dislocations traversantes issues des ouvertures du masque. En conséquence, elles n'émergent plus en surface.

L'invention a plus particulièrement pour objet un procédé tel que décrit ci-dessus, caractérisé en ce que la dissymétrie est induite par la réalisation d'ouvertures soit dans le masque de diélectrique soit directement dans le substrat, adjacentes inégales dissymétriques formant un motif de base d'un réseau périodique, le motif de base comportant au minimum 2 ouvertures, ces ouvertures pouvant être de différents types et notamment des lignes, des hexagones, des triangles ou une combinaison de ces ouvertures. Préférentiellement, le réseau périodique définit ci-dessus s'étend selon une direction [10-10].
La technologie ELO selon la présente invention est identifiée sous l'acronyme ALFAGEO pour Asymetric Lateral Facet Grown-Epitaxial Overgrowth.

La ou les étapes de surcroissance épitaxiale latérale (ELO) sont avantageusement effectuées par épitaxie en phase vapeur à partir de chlorures et d'hydrures (HVPE), par épitaxie en phase vapeur par pyrolyse d'organométalliques (EPVOM) ou encore par CSVT (Close Space Vapor Transport).

Dans l'objectif de supprimer le champ piézoélectrique, qui existe lorsqu'on réalise l'épitaxie selon le plan C(0001), on peut également réaliser ces étapes de surcroissance épitaxiale latérale (ELO) selon un des plans M(1-100), A(11-20), R(1-102), S(10-11) et N(11-23) du substrat.

Les substrats peuvent présenter une épaisseur de quelques centaines de micromètres, généralement de l'ordre de 200 µm et peuvent être choisis parmi le saphir, ZnO, 6H-SiC, 4H-SiC, 3C-SiC, GaN, AIN, LiAlO₂, LiGaO₂, MgAlO₄ Si, HfB₂ ou GaAs. Les substrats peuvent être traités préalablement à tout dépôt de GaN par nitruration.

L'invention concerne également tout film de GaN susceptible d'être obtenu par le procédé selon l'invention. Le film de GaN ainsi obtenu peut présenter une épaisseur variant de 1 à 100 µm. Selon un mode particulier de réalisation de l'invention, le film de GaN obtenu peut présenter une épaisseur variant de 5 à 15 µm.

On propose également un composant optoélectronique et notamment une diode laser, un photodétecteur ou un transistor, caractérisé en ce qu'il est muni d'un film de GaN susceptible d'être obtenu par le procédé de l'invention.

Ainsi selon une première variante de l'invention les ouvertures sont effectuées dans un masque de diélectrique et selon une deuxième variante de l'invention, les ouvertures sont effectuées directement dans le substrat.

Lorsque les ouvertures sont effectuées dans le masque de diélectrique, à savoir selon la première variante, le procédé comporte avantageusement deux étapes de surcroissance épitaxiale latérale (ELO), selon la technique décrite plus haut.
Un des buts de l'invention est ainsi de proposer un procédé de réalisation d'un film de GaN qui fournit un film de GaN, dont les dislocations provenant du milieu des ouvertures et des joints de coalescence sont fortement réduites en densité dans le cas où le procédé à deux étapes d'épitaxie est adopté pour la réalisation dudit film de GaN.

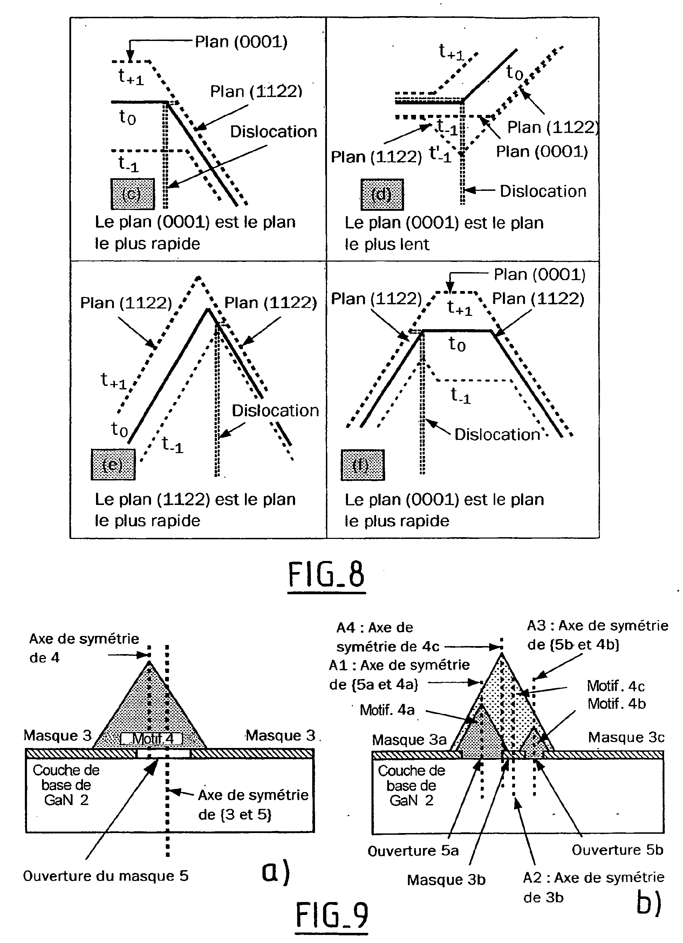

Les cas où les facettes {11-22} croissent à une vitesse différente de sorte à provoquer une courbure des lignes de dislocation ou les cas où les ouvertures dans le masque conduisent à des facettes de surface différente sont illustrés par les figures 8 et 9. Dans cette figure 8, t₀ désigne le premier instant où la dislocation peut se courber; à t₁ (précédent t₀) la dislocation se trouve dans une configuration d'environnement symétrique tel que (a) pour (c) et (d) ou tel que (b) pour (e) et (f). A t₊₁ la dislocation se propage dans le plan basal (0001). La configuration (c) est celle qui est exploitée dans l'ELO à deux étapes décrite précédemment. Dans la configuration (d), t₋₁ et t'₋₁ montrent deux géométries possibles qui aboutissent à la même forme à t₀.
Dans la suite de la description, on se référera à cette figure lorsqu'on évoquera les cas de figures typiques de dissymétrie (c), (d), (e) et (f).
Dans le cas (1) ci-dessus, on applique une dissymétrie selon le cas de figure (e) et dans le cas (2) on applique une dissymétrie selon la cas (d) et (f).
La dissymétrie en application de la configuration (d) peut aussi être mise à profit pour éliminer les joints de coalescence, ce qui conduit à une surface ELO totalement utilisable pour la fabrication des composants optoélectroniques.

Les masques de diélectrique utiles pour réaliser cette variante du procédé selon l'invention peuvent être constitués de nitrure de silicium (SiN), SiO₂ ou W. On réalise le dépôt du diélectrique selon des techniques bien connues de l'homme de l'art.
On peut réaliser le premier dépôt de GaN par toutes les méthodes de dépôt en phase vapeur à savoir l'HVPE (Hydride Vapor Phase Epitaxy ou épitaxie en phase vapeur à partir de chlorures et d'hydrures), l'EPVOM (épitaxie en phase vapeur par pyrolyse d'organométalliques) ou la CSVT (Close Space Vapor Transport). De préférence on utilise l'EPVOM. De préférence, le gaz vecteur est un mélange N₂, H₂. On peut utiliser encore d'autres technologies d'épitaxie en phase vapeur pour cette première couche comme la MBE, la pulvérisation cathodique ou l'ablation laser.

A titre de couche de base de GaN sur laquelle on effectue un masquage suivi d'une reprise épitaxiale, on peut avantageusement utiliser une couche de GaN obtenue selon le procédé qui suit :
On recouvre le substrat par une épaisseur de nitrure de silicium de l'ordre du plan atomique. Après achèvement de la formation du masque de diélectrique, on dépose une couche de GaN, dite couche tampon continue. L'épaisseur de cette couche peut être comprise entre 20 et 30 nm. La température lors de cette opération peut être comprise entre 300 et 900°C. On procède ensuite à un recuit à haute température comprise entre 950 et 1120°C. La couche tampon se converti d'une couche continue à une couche discontinue formée de motifs de GaN, ou autrement dit de motifs de GaN sous forme d'îlots. Les zones où le diélectrique est mis à nu fonctionnent alors comme un masque et les motifs de GaN fonctionnent comme les zones de GaN localisées dans les ouvertures réalisées *ex-situ* dans le masque. Après le dépôt de la couche de nucléation et son recuit, on dépose par épitaxie en phase vapeur par pyrolyse d'organométalliques une couche mince de GaN de 2 à 5 µm d'épaisseur typique. La source de gallium est le Triméthylgallium (TMGa) et la source d'azote est l'ammoniac. Une telle méthode est décrite dans de nombreux documents. Cette technique est notamment décrite dans la demande de brevet WO99/20816 à l'exemple 5 que l'on incorpore ici par référence.
Utiliser cette couche de GaN de base présente l'avantage de limiter la densité de dislocation dès le début du procédé selon l'invention.

On décrit ci-après différents modes de réalisation possibles de la première variante de l'invention, qui ne limitent pas la portée de l'invention mais ont vocation à l'illustrer.
Tous les modes de réalisation décrits ci-après concernent des procédés ELO à deux étapes, tels que décrits plus haut.
Ainsi l'invention concerne plus particulièrement un procédé de réalisation d'un film de GaN, caractérisé en ce que le dépôt de GaN qui suit la formation des ouvertures se décompose en deux étapes d'épitaxie, la première étant effectuée dans des conditions de croissance de sorte que la vitesse de croissance le long de la direction <0001> est supérieure à la vitesse de croissance latérale et la deuxième étant effectuée dans des conditions expérimentales modifiées de sorte que la vitesse de croissance latérale soit supérieure à celle selon la direction <0001> de façon à obtenir une coalescence totale des motifs.
La modification des conditions de croissance pour obtenir que la vitesse de croissance latérale soit supérieure à celle selon la direction <0001> consiste en l'ajout de magnésium, d'antimoine ou de bismuth.

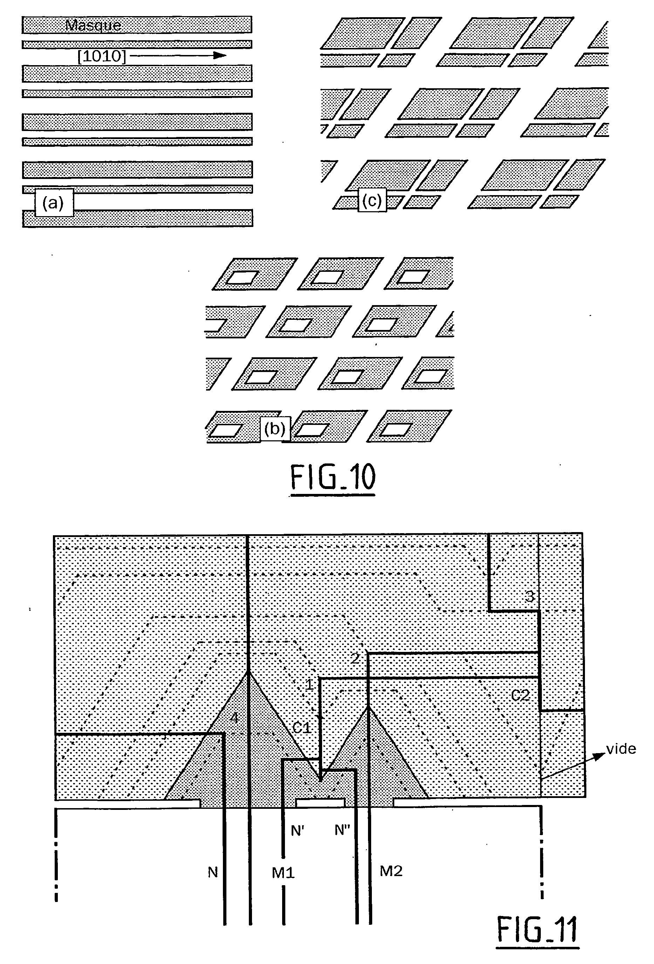

Selon **un premier mode de réalisation** on réalise des ouvertures adjacentes inégales dissymétriques formant le motif de base d'un réseau périodique selon de préférence une direction [10-10]. Des exemples de tels motifs d'ouverture dissymétriques sont représentés à la figure 10. Le motif de base dissymétrique n'est pas limité à des ouvertures linéaires, on peut imaginer bien d'autres motifs tels que des ouvertures hexagonales parallèles aux directions [10-10] ou triangulaires. Le fondement de l'invention est d'induire par la dissymétrie des ouvertures une propagation des dislocations qui conduit à une réduction plus élevée de leur densité que dans l'ELO.

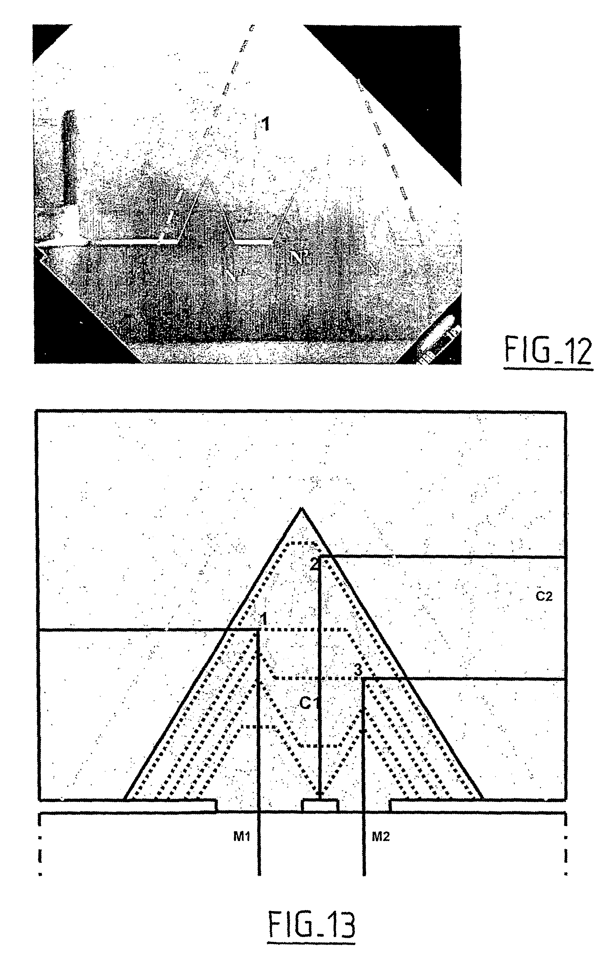

Après avoir réalisé ces ouvertures dissymétriques on reprend le substrat épitaxié, masqué et gravé, par exemple selon la figure 10 dans des conditions de dépôt, par épitaxie de nitrure de gallium de façon à induire le dépôt de motifs de nitrures de gallium sur les zones en regard et la croissance anisotrope et latérale desdits motifs, la croissance latérale étant poursuivie jusqu' à la coalescence desdits motifs.
A titre d'exemple, la figure 11 schématise l'évolution de la morphologie lors de l'ELO de GaN quand les ouvertures sont de largeur inégale.
Lors de la première étape, les conditions de croissance sont choisies pour que le plan (0001) soit un plan rapide. Cette première étape se termine lorsque le plan (0001) a disparu, tous les motifs de GaN obtenus par croissance à partir des ouvertures inégales atteignent alors une section triangulaire : la section du motif de GaN correspond au trait noir épais délimitant les deux zones distinctes de grisé sur la figure 11.
Lors de cette première étape, (surface gris foncé limitée par le trait noir sur la figure 11), les dislocations traversantes se courbent à 90° quand elles rencontrent les facettes latérales {11-22} en cours de croissance (tel que N qui se trouve au point 4 en configuration (c)). Les dislocations situées exactement au milieu des petites et grandes ouvertures ne sont pas courbées (notées M1 et M2) et continuent à se propager verticalement au delà de cette première étape. De même, si les motifs coalescent déjà à ce stade comme c'est le cas sur la figure 11, les dislocations telles que N' et N" convergent vers le joint de coalescence (notés C1) se propagent verticalement au delà de cette première étape. Il se forme aussi un vide au milieu des masques.
Dans la seconde étape, où les conditions de croissance sont modifiées, les facettes (0001) réapparaissent. Ce deuxième temps de l'ELO consiste en la reprise en épitaxie en modifiant les conditions de croissance pour changer l'anisotropie de croissance pour qu'elle devienne favorable à la planérisation des motifs de GaN. Comme décrit dans WO 99/20816, ceci peut être obtenu soit en ajoutant du magnésium dans la phase vapeur soit en augmentant le température. Durant ce deuxième temps, les motifs de GaN se développent avec une expansion de la facette (0001) (qui réapparaît au sommet de chaque motif) tandis que la surface des facettes latérales diminue. A cause de la dissymétrie du motif, les dislocations M2 des petites ouvertures et C1, C2 des joints de coalescence émergent dans des facettes latérales {11-22} en configuration de type (d) aux points 2, 1 et 3 respectivement, où elles subissent une courbure à 90°. Dans ce mode de réalisation, les dislocations, peu nombreuses, de type M1 ne sont pas courbées. Par contre, celles de type C2, très nombreuses, sont courbées en 3 dans le plan basal et vont pouvoir interagir et s'annihiler. La figure 12, illustre ce comportement des dislocations, on identifie le comportement de dislocations de type N, N' et N" des grandes et petites ouvertures respectivement et de type C1 qui se courbe en 1.

Selon **un deuxième mode de réalisation** on met en oeuvre des ouvertures inégales d'une façon différente du premier mode de réalisation.
La figure 13 illustre un exemple de réalisation de ce deuxième mode de réalisation.
Comme dans le premier mode de réalisation, la croissance se déroule en deux étapes différant par les conditions de croissance.
Mais pour ce deuxième mode de réalisation, la première étape se termine lorsque les motifs de GaN issus des ouvertures inégales du masque ont complètement coalescés pour former un motif unique présentant une section triangulaire. Les géométries intermédiaires que l'on peut observer au cours de la première étape sont indiquées en trait pointillé noir sur la figure 13.
Dans la deuxième étape, les conditions de croissance sont choisies pour obtenir une planarisation en faisant réapparaître le plan basal C (0001) comme indiqué en trait pointillé gris sur la figure 11.

Les dislocations de types C1 et M2 se courbent pour les raisons invoquées dans la description du premier mode de réalisation.
Ce deuxième mode de réalisation diffère du premier dans le comportement des dislocations de type M1 et C2. Les dislocations de type M1 sont courbées au point 1 parce que, en ce point, M1 se trouve dans une configuration (c). Par contre les dislocations de type C2 ne se courbent pas.

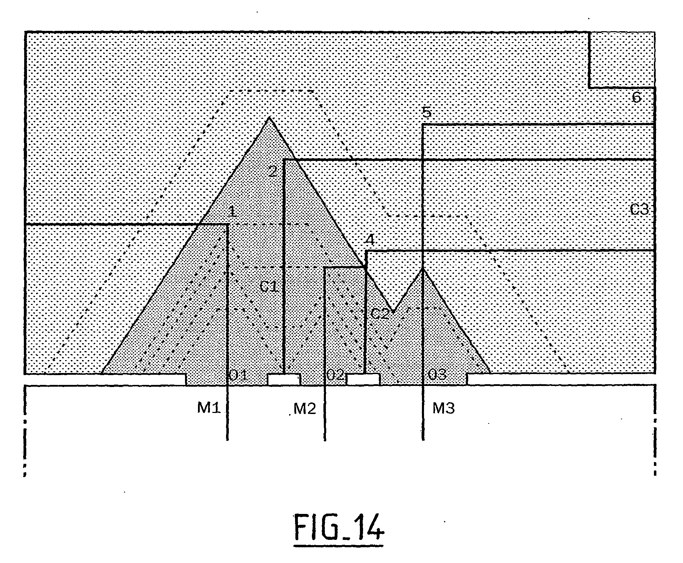

Selon **un troisième mode de réalisation** on met en oeuvre trois ouvertures inégales.
Les deux modes de réalisation précédents laissent échapper un type de dislocation : M1 dans la premier mode de réalisation, C2 dans le deuxième mode de réalisation. Il est possible de combiner les deux premiers modes de réalisation en un troisième qui permet de courber à la fois le type M1 et le type C2. Il y a de nouveau deux étapes différentes par les conditions de croissance. Ce troisième mode de réalisation est illustré sur la figure 14.
Lors de la première étape, les motifs de GaN issus des ouvertures inégales O1 et O2 coalescent pour former un motif à section triangulaire unique et les dislocations M1 sont courbées : on retrouve le deuxième mode de réalisation. Dans le même temps le motif issu de l'ouverture 03, située suffisamment loin de 02, se développe pour atteindre une section triangulaire. La fin de la première étape coïncide avec l'obtention d'un profil en trait noir sur la figure 14 : on retrouve le profil du premier mode de réalisation. Les joints de grains (C3 sur la figure 14) sont courbés en 6.

Selon **un quatrième mode de réalisation** on introduit une dissymétrie lors de la croissance.
Comme il a été mentionné en introduction, la dissymétrie peut aussi être créée en éclairant latéralement le substrat en cours de croissance avec un rayonnement UV de manière à augmenter la vitesse de croissance d'une seule famille de facettes {1-212}. L'application d'un champ électrique perpendiculairement à la direction des ouvertures est aussi possible. En partant de motifs gravés symétriques (ou inégales pour combiner les effets), après coalescence à la fin de la première étape (ou dès le début de la première étape), on introduit une dissymétrie dans la croissance en augmentant la vitesse de croissance d'une des 2 facettes équivalentes {11-22} (par exemple en éclairant latéralement la structure avec un laser UV, ou en appliquant un champ électrique perpendiculairement à la directions des ouvertures).
Les dislocations traversantes M situées au milieu du masque ne sont pas courbées dans la première phase de l'ELO, par contre elles le sont en 1 (Fig. 8 (e) lorsque l'on introduit une dissymétrie dans la vitesse de croissance des facettes {11-22}. Il résulte de la dissymétrie un joint de coalescence qui n'est plus perpendiculaire à la surface du substrat, de telle sorte que les dislocations, après avoir été courbée à 90°, se rejoignent dans le joint de coalescence. Dans ce joint, où souvent apparaît un vide, une partie des dislocations s'arrête, une partie se propage vers le bas, et une autre partie se propage verticalement, notée C. Ces dernières rencontrent en 2 une facette {11-22} et se courbent à 90°.

Lorsque les ouvertures sont gravées directement dans le substrat, à savoir selon la deuxième variante, l'étape de formation de la couche de base de GaN peut être effectuée dans les mêmes conditions que décrites ci-dessus, c'est-à-dire lorsque l'on met en oeuvre la première variante du procédé.

De même, cette deuxième variante peut avantageusement comporter deux étapes de surcroissance latérale (ELO) qui peuvent être effectuées dans les mêmes conditions que décrites ci-dessus, c'est-à-dire lorsque l'on met en oeuvre la première variante du procédé.

Les caractéristiques, buts et avantages de l'invention apparaissent aussi à la lecture de l'exemple qui va suivre d'un mode particulier de réalisation de l'invention et des figures annexées sur lesquelles :
- la figure 1 est une représentation d'une épitaxie à une étape ;
- la figure 2 est une représentation d'une première étape de surcroissance épitaxiale latérale à deux étapes ;
- la figure 3 est une représentation d'une seconde étape de cette surcroissance épitaxiale latérale ;
- la figure 4 représente l'évolution de la structure avant coalescence totale. Les dislocations se propagent parallèlement au plan de base. Les lignes pointillées représentent les différentes forme possibles des motifs ELO à la fin de la première étape ;
- La figure 5 est un ensemble de 2 images de la surface en cathodoluminescence. Chaque point noir correspond à l'émergence d'une dislocation traversante. La partie (a) de l'image représente une surface de GaN élaboré selon le procédé à deux étapes d'épitaxie et la partie (b) de l'image représente une surface de GaN élaboré selon le procédé à une étape. La marque * a un diamètre de 20 µm ;
- La figure 6 représente 3 exemples de configuration où la dislocation se propage dans un environnement qui reste symétrique pendant la croissance (les traits gras pleins t₀ et pointillés t₁ figurent deux positions successives dans le temps des plans C en (a) et (11-22) en (b) et (b') ;
- La figure 7 représente un cas de croissance symétrique où la surcroissance de GaN et l'ouverture 5 ont un axe de symétrie commun ;
- La figure 8 représente des cas de croissance asymétrique ;
- La figure 9(a) représente un cas de croissance assymétrique obtenue lorsque la facette gauche croît plus rapidement que la facette droite : 4 et {3 et 5} ont des axes (ou plans) de symétrie disjoints. Toutes les dislocations issues de l'ouverture du masque se trouvent à un moment donné en configuration (c) ou (e). Il y aura courbure;
- La figure 9(b) représente un cas d'asymétrie obtenue par le choix de la forme inégale des ouvertures 5a et 5b : les surcroissances 4a et 4b coalescent pour former un ruban 4c dont le plan de symétrie A4 ne coïncide par construction avec aucun des autres plans de symétrie (A1, A2, A3). Toutes les dislocations issues des ouvertures du masque 5a et 5b ou bien se propageant verticalement au dessus du masque 3b se trouvent à un moment donné en configuration (c). Il y aura courbure ;
- La figure 10 représente en (a) un masque avec des ouvertures le long d'une direction [1-100] avec des ouvertures de largeur inégales, en (b) et (c) un masque avec des ouvertures le long de 2 directions de type [1-100] ;
- La figure 11 est une représentation schématique d'un procédé d'ELO à deux étapes à partir d'ouvertures dans le masque de largeur inégale. La première étape apparaît en trait noir épais et la deuxième étape de planérisation apparaît en trait pointillé ;
- La figure 12 représente la structure des dislocations traversantes dans une couche de GaN réalisée par un procédé ELO à deux étapes, à partir d'ouvertures dissymétriques. En trait blanc apparaît la section des 2 motifs coalescés au cours de la première étape. On identifie les dislocations qui se courbent à 90°, on n'observe pas de dislocation de type M dans le motif le plus petit. En tirets gris on observe la facette {11-22} qui se développe au cours de la seconde étape. Les dislocations de type C qui ont pour origine le joint de coalescence se courbent à 90° quand elles rencontrent cette facette (point 2).
- La figure 13 représente l'évolution des motifs de GaN lors d'une mise en oeuvre du procédé selon le deuxième mode de réalisation décrit plus haut ;
- La figure 14 représente l'évolution des motifs de GaN lors d'une mise en oeuvre du procédé selon le troisième mode de réalisation décrit plus haut.

### Exemple

La première partie de l'exemple a été reprise de l'exemple 1 de WO 99/20816.
On utilise un réacteur vertical approprié opérant à pression atmosphérique pour l'épitaxie en Phase Vapeur par Pyrolyse d'Organométalliques. Sur un substrat de saphir (0001) de 200 à 500 µm d'épaisseur on dépose par épitaxie une couche mince de nitrure de gallium de 2 µm d'épaisseur, en Phase Vapeur par Pyrolyse d'Organométalliques à 1080°C. La source de gallium est le triméthylgallium (TMGa) et la source d'azote est l'ammoniac. Une telle méthode est décrite dans de nombreux documents.

Les conditions expérimentales sont les suivantes :
Le véhicule gazeux est un mélange d'H₂ et N₂ en proportions égales (4 sl/mn). L'ammoniac est introduit par un conduit séparé (2 sl/mn).
Après la croissance de la première couche épitaxiale de nitrure de gallium, une fine couche de nitrure de silicium est déposée dans la chambre de croissance. Des ouvertures dissymétriques sont pratiquées dans le diélectrique par photolithographie, avec des ouvertures de 1 µm et 2 µm (masque de la figure 10(a)). Les ouvertures linéaires sont avantageusement orientées selon une direction [10-10] de GaN bien que le procédé décrit dans cet exemple puisse être conduit à terme pour d'autres orientations des ouvertures notamment selon [11-20] de GaN. On effectue la reprise par épitaxie sur les zones dégagées par du GaN non intentionnellement dopé dans des conditions opératoires de la première reprise d'épitaxie du procédé à deux étapes telle que la vitesse de croissance selon la direction [0001] des motifs de GaN excède suffisamment la vitesse de croissance selon la direction normale aux flancs inclinés des dits motifs. Dans ces conditions l'anisotropie de croissance conduit à la disparition de la facette (0001). Le premier temps de la mise en oeuvre du procédé s'achève lorsque que la disparition de la facette (0001) du motif de GaN est assurée. En fin du premier temps, les motifs ont pris la forme de bandes à section triangulaire (avec des facettes latérales d'orientation {11-22} ou {1-101} selon que les bandes initiales aient été orientées selon [10-10] ou [11-20]) de taille inégale (Fig. 12).
Le deuxième temps consiste en la reprise en épitaxie par du GaN en modifiant l'anisotropie de croissance (en portant la température à 1120°C ou en ajoutant du magnésium sous forme d'organométallique volatil (MeCp2Mg) dans la phase vapeur). Le débit de TMGa est de 100µmole/minute. La facette (0001) réapparaît au sommet de chacun des motifs de GaN obtenus dans la première phase. Ensuite, ces motifs de GaN se développent avec une expansion des facettes (0001) et au contraire une diminution des flancs. En raison de la dissymétrie des motifs triangulaires deux flancs adjacents (provenant de motifs de taille différente) coalescent avant la coalescence totale de tous les motifs. Dans cette variante de l'ELO, la zone de coalescence (ou joint de coalescence) de deux motifs n'est plus un plan parallèle aux ouvertures mais un plan incliné d'un angle déterminé par le rapport entre les vitesses de croissance le long de l'axe c et latéralement. Le deuxième temps prend fin lorsque tous les flancs ont entièrement disparus, la surface supérieure du dépôt formée par les motifs coalescés de GaN étant alors plane.
La mise en oeuvre du procédé selon l'invention comme décrit ci-dessus conduit d'une part à l'obtention d'une couche de GaN plane, pouvant donc servir de substrat pour le dépôt ultérieur, par reprise d'épitaxie, de structure de composants, notamment de structure de diode laser, mais conduit d'autre part à une amélioration très avantageuse de la qualité cristalline dudit substrat. En effet, les lignes de dislocations provenant de couche de GaN sous-jacente se propagent par les ouvertures pratiquées dans le masque verticalement dans les motifs crées dans un premier temps. Mais il apparaît que les lignes de dislocations se courbent à 90° dans un deuxième temps.
La figure 12 représente ainsi une image en microscopie électronique à haute résolution de la couche ainsi obtenue, au dessus de chaque ouverture les dislocations se courbent à 90° quand au cours de la croissance elles rencontrent les facettes {11-22}. Seules peuvent échapper, au début de cette phase de la croissance les dislocations ayant leur origine au centre du masque. Ensuite les lignes de défauts se propagent dans des directions parallèles à la surface de la couche de GaN masqué.

## Revendications

1. Procédé de réalisation d'un film de nitrure de gallium (GaN) à partir d'un substrat, par dépôt de GaN par épitaxie en phase vapeur, le dépôt de GaN comportant au moins une étape de surcroissance épitaxiale latérale en phase vapeur (ELO), au moins une de ces étapes d'ELO étant précédée d'une gravure d'ouvertures
- soit dans un masque de diélectrique préalablement déposé,
- soit directement dans le substrat,
**caractérisé en ce que** l'on introduit une dissymétrie dans l'environnement des dislocations lors d'une des étapes d'ELO de façon à provoquer le plus grand nombre de courbures des dislocations, les dislocations courbées n'émergeant pas à la surface de la couche de GaN ainsi obtenue, la dissymétrie étant induite :
(1) en agissant sur les paramètres de la croissance soit en appliquant un champ électrique perpendiculaire à l'axe de croissance, ou un champ magnétique soit encore en éclairant à l'aide d'une lampe produisant un rayonnement UV de 170 à 400 nm, pour faire croître préférentiellement une seule famille de facettes {11-22} ou encore;
(2) en réalisant des ouvertures de largeurs ou de géométrie inégales soit dans le masque de diélectrique soit directement dans le substrat pour faire prendre des formes géométriques aux motifs de GaN favorables à la courbure des dislocations.

2. Procédé selon la revendication 1, **caractérisé en ce que** la dissymétrie est induite par la réalisation d'ouvertures soit dans le masque de diélectrique soit directement dans le substrat, adjacentes inégales dissymétriques formant un motif de base d'un réseau périodique, le motif de base comportant au minimum 2 ouvertures.

3. Procédé selon la revendication 2, **caractérisé en ce que** les ouvertures sont des lignes, des hexagones, des triangles ou une combinaison de ces ouvertures.

4. Procédé selon la revendication 2 ou 3, **caractérisé en ce que** le réseau périodique s'étend selon la direction [10-10].

5. Procédé selon l'une quelconque des revendications 1 à 4, **caractérisé en ce que** la ou les étapes de surcroissance épitaxiale latérale (ELO) sont effectuées par épitaxie en phase vapeur à partir de chlorures et d'hydrures (HVPE), par épitaxie en phase vapeur par pyrolyse d'organométalliques (EPVOM) ou encore par CSVT (Close Space Vapor Transport).

6. Procédé selon l'une quelconque des revendications 1 à 5, **caractérisé en ce que** la ou les étapes de surcroissance épitaxiale latérale (ELO) sont effectuées selon un des plans C(0001), M(1-100), A(11-20), R(1-102), S(10-11) et N(11-23) du substrat.

7. Procédé selon l'une quelconque des revendications 1 à 6, **caractérisé en ce que** le substrat est choisi parmi le saphir, ZnO, 6H-SiC, 4H-SiC. 3C-SiC, GaN, AIN, LiAlO₂, LiGaO₂, MgAlO₄. Si, HfB₂ ou GaAs.

8. Procédé selon la revendication 7, **caractérisé en ce que** le substrat est un substrat en saphir.

9. Procédé selon l'une quelconque des revendications 1 à 8, **caractérisé en ce que** le nitrure de gallium est dopé lors d'au moins une des étapes de surcroissance épitaxiale latérale en phase vapeur par une substance dopante pouvant être choisie parmi le magnésium, le zinc, le béryllium, le calcium, le carbone, le silicium, l'oxygène, l'étain ou le germanium.

10. Procédé selon l'une quelconque des revendications 1 à 9, **caractérisé en ce que** l'on introduit dans le nitrure de gallium une impureté isoélectrique comme le In, Ie Sc, le Sb ou le Bi.

11. Procédé selon l'une quelconque des revendications 1 à 10, **caractérisé en ce que** les ouvertures sont gravées dans un masque de diélectrique.

12. Procédé selon la revendication 11, **caractérisé en ce que** l'on met en oeuvre une couche de base de GaN préalablement au dépôt du masque de diélectrique, par la technologie par épitaxie en phase vapeur à partir de chlorures et d'hydrures (HVPE), par l'épitaxie phase vapeur par pyrolyse d'organométalliques (EPVOM) ou encore par CSVT (Close Space Vapor Transport).

13. Procédé selon la revendication 12, **caractérisé en ce que** la formation de la couche de GaN de base comporte les étapes suivantes :
- dépôt de nitrure de silicium d'une épaisseur de l'ordre du plan atomique,
- dépôt d'une couche tampon de GaN,
- recuit à haute température comprise entre 950 et 1120°C de sorte que la couche tampon se convertit d'une couche continue à une couche discontinue formée de motifs de GaN sous forme d'îlots puis,
- dépôt par épitaxie de GaN.

14. Procédé de réalisation d'un film de nitrure de gallium (GaN) selon l'une quelconque des revendications 11 à 13, **caractérisé en ce que** le procédé comporte deux étapes de surcroissance épitaxiale latérale en phase vapeur (ELO) distinctes, le dépôt de GaN lors de la première étape étant effectué dans les zones de GaN localisées dans les ouvertures et le dépôt de GaN lors de la deuxième étape donnant lieu à une surcroissance latérale jusqu'à coalescence des motifs de GaN.

15. Procédé selon la revendication 14, **caractérisé en ce que** le dépôt de GaN lors de la première étape est effectué dans des conditions de croissance de sorte que la vitesse de croissance le long de la direction <0001> est supérieure à la vitesse de croissance latérale et le dépôt de GaN lors de la deuxième étape est effectué dans des conditions expérimentales modifiées de sorte que la vitesse de croissance latérale est supérieure à celle selon la direction <0001>, de façon à obtenir une coalescence totale des motifs.

16. Procédé selon la revendication 15, **caractérisé en ce que** la modification des conditions de croissance pour obtenir que la vitesse de croissance latérale soit supérieure à celle selon la direction <0001> consiste en l'ajout de magnésium, d'antimoine ou de bismuth.

17. Procédé selon l'une quelconque des revendications 1 à 10, **caractérisé en ce que** les ouvertures sont gravées directement dans le substrat

18. Procédé selon la revendication 17, **caractérisé en ce qu'**il est mis en oeuvre selon les conditions opératoires décrites dans les revendications 14à17.

## Claims

1. Process for producing a gallium nitride (GaN) film on a substrate by depositing GaN by vapour phase epitaxy, the GaN deposition including at least one vapour-phase epitaxial lateral overgrowth (ELO) step, at least one of these ELO steps being preceded by a step of etching apertures:
- either in a dielectric mask deposited beforehand
- or directly in the substrate,
**characterized in that** an asymmetry is introduced into the dislocation environment during one of the ELO steps so as to produce dislocations with the largest number of curvatures, the curved dislocations not emerging at the surface of the GaN layer thus obtained, the asymmetry being induced:
(1) by varying the growth parameters either by applying an electric field perpendicular to the growth axis, or applying a magnetic field, or else by illuminating using a lamp producing UV radiation of 170 to 400 nm, for preferential growth of a single family of {112̅2} facets or else;
(2) by producing apertures of unequal width or geometry, either in the dielectric mask or directly in the substrate in order to give the GaN patterns geometric shapes favourable to dislocation curvature.

2. Process according to Claim 1, **characterized in that** the asymmetry is induced by producing apertures either in the dielectric mask or directly in the substrate, these being adjacent, unequal and asymmetric and forming a base pattern of a periodic lattice, the base pattern comprising a minimum of two apertures.

3. Process according to Claim 2, **characterized in that** the apertures form lines, hexagons, triangles or a combination of these apertures.

4. Process according to Claim 2 or 3, **characterized in that** the periodic lattice extends along the [101̅0] direction.

5. Process according to any one of Claims 1 to 4, **characterized in that** the lateral epitaxial overgrowth (ELO) steps are carried out by vapour phase epitaxy using chlorides and hydrides (HVPE), by organometallic vapour phase epitaxy (OMVPE) or close-space vapour transport (CSVT).

6. Process according to any one of Claims 1 to 5, **characterized in that** the ELO step or steps are carried out on one of the C(0001), M(11̅00) A(1120) R(11̅02.) S(101̅1) and N(112̅3) planes of the substrate.

7. Process according to any one of Claims 1 to 6, **characterized in that** the substrate is selected from sapphire, ZnO, 6H-SiC, 4H-SiC, 3C-SiC, GaN, AIN, LiAlO₂, LiGaO₂ MgAlO₄, Si, HfB₂ and GaAs.

8. Process according to Claim 7, **characterized in that** the substrate is a sapphire substrate.

9. Process according to any one of Claims 1 to 8, **characterized in that** the gallium nitride is doped during at least one of the vapour-phase epitaxial lateral overgrowth steps by a dopant that may be selected from magnesium, zinc, beryllium, calcium, carbon, silicon, oxygen, tin and germanium.

10. Process according to any one of Claims 1 to 9, **characterized in that** an isoelectric impurity such as In, Sc, Sb or Bi is introduced into the gallium nitride.

11. Process according to any one of Claims 1 to 10, **characterized in that** the apertures are etched in a dielectric mask.

12. Process according to Claim 11, **characterized in that**, prior to the deposition of the dielectric mask, a GaN base layer is formed by vapour phase epitaxy technology using chlorides and hydrides (HVPE), by OMVPE or by CSVT.

13. Process according to Claim 12, **characterized in that** the formation of the GaN base layer comprises the following steps:
- deposition of silicon nitride with a thickness of the order of an atomic plan;
- deposition of a GaN buffer layer;
- high-temperature annealing between 950 and 1120°C so that the buffer layer is converted from a continuous layer to a discontinuous layer consisting of GaN patterns in the form of islands; and then
- deposition of GaN by epitaxy.

14. Process for producing a gallium nitride (GaN) film according to any one of Claims 11 to 13, **characterized in that** the process comprises two separate ELO steps, the GaN deposition during the first step being carried out in the GaN zones located in the apertures and the GaN deposition during the second step giving rise to lateral overgrowth until the GaN patterns coalesce.

15. Process according to Claim 14, **characterized in that** the GaN deposition during the first step is carried out under growth conditions such that the growth rate along the <0001> direction is greater than the lateral growth rate, and the GaN deposition during the second step is carried out under modified experimental conditions such that the lateral growth rate is greater than that along the <0001> direction, as to obtain complete coalescence of the patterns.

16. Process according to Claim 15, **characterized in that** the modification in the growth conditions to ensure that the lateral growth rate is greater than that along the <0001> direction consists in adding magnesium, antimony or bismuth.

17. Process according to any one of Claims 1 to 10, **characterized in that** the apertures are etched directly in the substrate.

18. Process according to Claim 17, **characterized in that** it is carried out according to the operating conditions described in Claims 14 to 17.

## Patentansprüche

1. Verfahren zur Herstellung eines Galliumnitrid-Films (GaN) ausgehend von einem Substrat durch Abscheidung von GaN durch Epitaxie in der Gasphase, wobei die Abscheidung von GaN wenigstens einen Schritt des seitlichen epitaktischen Überwachstums in der Dampfphase (ELO) umfasst, wobei wenigstens einem dieser ELO-Schritte ein Ätzen von Öffnungen vorhergeht,
- entweder in einer vorher abgelagerten Dielektrikummaske
- oder direkt in dem Substrat,
**dadurch gekennzeichnet, dass** in die Umgebung von Dislokationen in einem der ELO-Schritte eine Asymmetrie eingeführt wird, um die größte Zahl von Krümmungen der Dislokationen hervorzurufen, wobei die gekrümmten Dislokationen nicht auf der Oberfläche der somit erhaltenen GaN-Schicht auftreten, wobei die Asymmetrie **dadurch** eingeführt wird, dass:
(1) auf die Wachstumsparameter eingewirkt wird, indem ein zur Wachstumsachse senkrechtes elektrisches Feld oder ein Magnetfeld angelegt wird oder indem eine Beleuchtung mit Hilfe einer Lampe erfolgt, die eine UV-Strahlung mit 170 bis 400 nm erzeugt, um vorzugsweise eine einzige Familie von Facetten {11-22} aufwachsen zu lassen, oder dass
(2) Öffnungen mit ungleichen Breiten oder ungleicher Geometrie entweder in der Dielektrikummaske oder direkt in dem Substrat hergestellt werden, um für die Muster von GaN geometrische Formen zu schaffen, die die Krümmung der Dislokationen begünstigen.

2. Verfahren nach Anspruch 1, **dadurch gekennzeichnet, dass** die Asymmetrie durch die Herstellung von Öffnungen entweder in der Dielektrikummaske oder direkt in dem Substrat eingeführt wird, wobei benachbarte ungleiche Asymmetrien ein Basismuster eines periodischen Gitters bilden, wobei das Basismuster wenigstens zwei Öffnungen aufweist.

3. Verfahren nach Anspruch 2, **dadurch gekennzeichnet, dass** die Öffnungen Linien, Sechsecke, Dreiecke oder eine Kombination dieser Öffnungen sind.

4. Verfahren nach Anspruch 2 oder 3, **dadurch gekennzeichnet, dass** sich das periodische Gitter in der Richtung [10-10] erstreckt.

5. Verfahren nach einem der Ansprüche 1 bis 4, **dadurch gekennzeichnet, dass** der oder die Schritte des seitlichen epitaktischen Überwachstums (ELO) durch Epitaxie in der Dampfphase ausgehend von Chlorwasserstoffen (HVPE), durch Epitaxie in der Dampfphase durch Pyrolyse von Organometallen (EPVOM) oder aber durch CSVT (Close Space Vapor Transport) ausgeführt wird oder werden.

6. Verfahren nach einem der Ansprüche 1 bis 5, **dadurch gekennzeichnet, dass** der oder die Schritte des seitlichen epitaktischen Überwachstums (ELO) in einer der Ebenen C(0001), M(1-100), A(11-20), R(1-102), S(10-11) und N(11-23) des Substrats ausgeführt wird oder werden.

7. Verfahren nach einem der Ansprüche 1 bis 6, **dadurch gekennzeichnet, dass** das Substrat aus Saphir, ZnO, 6H-SiC, 4H-SiC, 3C-SiC, GaN, AlN, LiAlO₂, LiGaO₂, MgAlO₄, Si, HfB₂ oder GaAs gewählt ist.

8. Verfahren nach Anspruch 7, **dadurch gekennzeichnet, dass** das Substrat ein Saphirsubstrat ist.

9. Verfahren nach einem der Ansprüche 1 bis 8, **dadurch gekennzeichnet, dass** das Galliumnitrid in wenigstens einem der Schritte des seitlichen epitaktischen Überwachstums in der Dampfphase mit einer Dotierstoffsubstanz dotiert wird, die aus Magnesium, Zink, Beryllium, Calcium, Kohlenstoff, Silicium, Sauerstoff, Zinn oder Germanium gewählt sein kann.

10. Verfahren nach einem der Ansprüche 1 bis 9, **dadurch gekennzeichnet, dass** in das Galliumnitrid isoelektrische Störstellen wie etwa In, Sc, Sb oder Bi eingeführt werden.

11. Verfahren nach einem der Ansprüche 1 bis 10, **dadurch gekennzeichnet, dass** die Öffnungen in eine Dielektrikummaske geätzt werden.

12. Verfahren nach Anspruch 11, **dadurch gekennzeichnet, dass** vor der Ablagerung der Dielektrikummaske eine GaN-Basisschicht durch die Technologie der Epitaxie in der Dampfphase ausgehend von Chlorwasserstoffen (HVPE), der Epitaxie in der Dampfphase durch Pyrolyse von Organometallen (EPVOM) oder von CSVT (Close Space Vapor Transport) eingesetzt wird.

13. Verfahren nach Anspruch 12, **dadurch gekennzeichnet, dass** die Bildung der GaN-Basisschicht die folgenden Schritte umfasst:
- Ablagern von Siliciumnitrid mit einer Dicke in der Größenordnung der Atomschicht,
- Ablagern einer GaN-Pufferschicht,
- Glühen bei hoher Temperatur im Bereich von 950 bis 1120 °C, derart, dass sich die Pufferschicht von einer ununterbrochenen Schicht in eine unterbrochene Schicht umwandelt, die aus Mustern von GaN in Form von Inseln gebildet ist, anschließend
- Ablagern von GaN durch Epitaxie.

14. Verfahren zur Herstellung eines Galliumnitrid-Films (GaN-Film) nach einem der Ansprüche 11 bis 13, **dadurch gekennzeichnet, dass** das Verfahren zwei verschiedene Schritte des seitlichen epitaktischen Überwachstums in der Dampfphase (ELO) umfasst, wobei die Ablagerung von GaN im ersten Schritt in den GaN-Zonen erfolgt, die sich in den Öffnungen befinden, und die Ablagerung von GaN im zweiten Schritt zu einem seitlichen Überwachstum bis zu einer Koaleszenz der GaN-Muster führt.

15. Verfahren nach Anspruch 14, **dadurch gekennzeichnet, dass** die Ablagerung von GaN im ersten Schritt unter Wachstumsbedingungen erfolgt, derart, dass die Wachstumsgeschwindigkeit in der Richtung <0001> größer ist als die seitliche Wachstumsgeschwindigkeit, und die Ablagerung von GaN im zweiten Schritt unter modifizierten experimentellen Bedingungen erfolgt, derart, dass die seitliche Wachstumsgeschwindigkeit größer als jene in der Richtung <0001> ist, derart, dass eine vollständige Koaleszenz der Muster erhalten wird.

16. Verfahren nach Anspruch 15, **dadurch gekennzeichnet, dass** die Modifizierung der Wachstumsbedingungen, um zu erzielen, dass die Geschwindigkeit des seitlichen Wachstums größer als jene in der Richtung <0001> ist, in der Hinzufügung von Magnesium, Antimon oder Wismut besteht.

17. Verfahren nach einem der Ansprüche 1 bis 10, **dadurch gekennzeichnet, dass** die Öffnungen direkt in das Substrat geätzt werden.

18. Verfahren nach Anspruch 17, **dadurch gekennzeichnet, dass** es unter Betriebsbedingungen ausgeführt wird, die in den Ansprüchen 14 bis 17 beschrieben sind.
